(19) **Europäisches Patentamt / European Patent Office / Office européen des brevets**

(11) **EP 3 579 412 A1**

(12) **EUROPEAN PATENT APPLICATION**

(43) Date of publication:
**11.12.2019 Bulletin 2019/50**

(51) Int Cl.:
***H03H 17/06*** (2006.01)

(21) Application number: **19177367.0**

(22) Date of filing: **29.05.2019**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **07.06.2018 US 201862681777 P**
**20.05.2019 US 201916416482**

(71) Applicant: **STMicroelectronics International N.V.**
**1118 BH Schiphol (NL)**

(72) Inventors:
• **BAL, Ankur**
**201308 Greater Noida (IN)**
• **SINGH, Vikram**
**135133 Radaur (IN)**
• **SINGH, Harvinder**
**201310 Greater Noida (IN)**

(74) Representative: **Smith, Gary John**
**Page White & Farrer**
**Bedford House**
**John Street**
**London, WC1N 2BF (GB)**

(54) **CASCADED INTEGRATOR-COMB (CIC) DECIMATION FILTER WITH INTEGRATION RESET TO SUPPORT A REDUCED NUMBER OF DIFFERENTIATORS**

(57)    A cascaded integrator-comb (CIC) decimation filter may include N integrator stages (52), N-1 differentiator stages (56), and a decimator (54) coupled to receive an integrated signal (60) that is output from the N integrator stage (52) and generate a decimated signal (62) that is input to the N-1 differentiator stages (56). The decimator (54) may periodically assert an integration reset signal (70). A last integrator stage of the N integrator stages (52) may be reset in response to assertion of the integration reset signal (70).

FIG. 5

EP 3 579 412 A1

**Description**

TECHNICAL FIELD

The present invention relates generally to a decimation filter and, more particularly, to an improved cascaded integrator-comb (CIC) decimation filter.

BACKGROUND

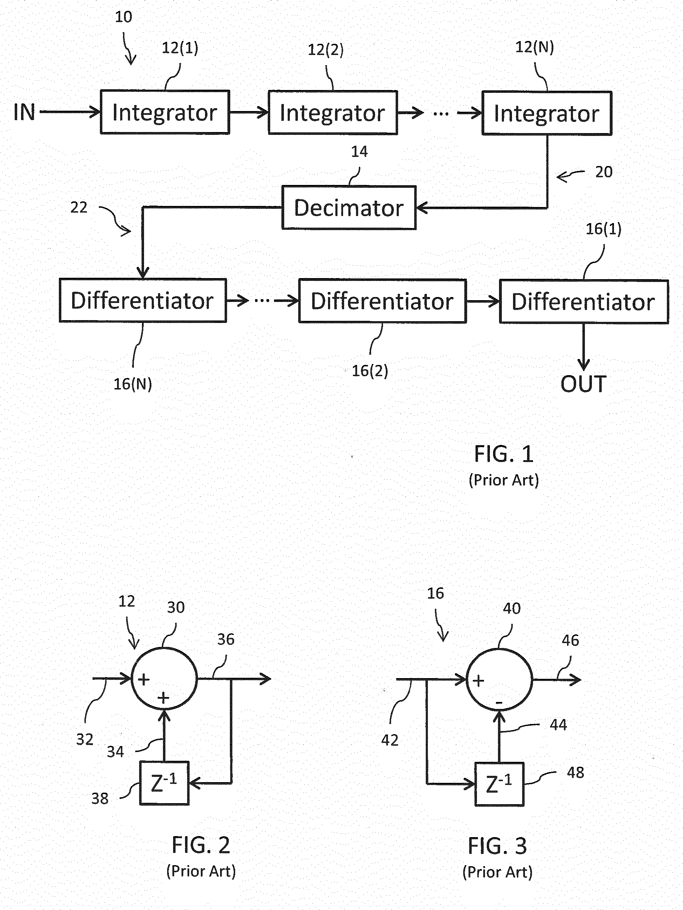

Reference is now made to Figure 1 which shows a schematic view of a conventional N-stage cascaded integrator-comb (CIC) decimation filter 10. A CIC decimation filter includes an equal number of stages of integrators 12 and differentiators (or combs) 16. In this example, there are N stages of integrators 12(1) to 12(N) and N stages of differentiators 16(1) to 16(N). The N integrators 12(1) to 12(N) are connected in series cascade with the (first) integrator 12(1) stage in the string having an input configured to receive an input signal IN (where the input signal IN is a digital signal and the integrators operate at a sampling frequency of the input digital signal). The output of the integrator 12(1) is coupled to the input of the next integrator 12(2) stage in the string, and this connectivity is repeated across the string of included integrator stages. The output of the (last) integrator 12(N) stage in the string produces an integration signal 20 that is applied to the input of a rate changer in the form of a decimator 14 (also referred to in the art as a down-sampler). The decimator 14 operates to decimate the integration signal 20 and generate a decimated signal 22. As an example, the decimator 14 may select for output as the decimated signal 22 every D-th sample of the integration signal 20 so as to provide a down sampling rate of D. The N differentiators 16(1) to 16(N) are connected in cascade series with the (first) differentiator 16(N) stage in the string having an input configured to receive the decimated signal 22. The output of the differentiator 16(N) is coupled to the input of the next differentiator 16(N-1) stage in the string, and this connectivity is repeated across the string of included differentiators. The output of the (last) differentiator 16(1) stage in the string produces an output signal OUT which is the result of filtering the input signal IN (where the output signal OUT is a digital signal and the differentiators operate at a sampling frequency of the output digital signal). The down sampling rate of D effectuates the rate change from the sampling frequency of the input digital signal to the sampling frequency of the output digital signal.

Each integrator 12, as shown schematically in Figure 2, comprises an adder 30 having a first input configured to receive an input signal 32 and a second input configured to receive a delay signal 34. The adder 30 operates to add the delay signal 34 to the input signal 32. The output signal 36 from the adder 30 is applied to the input of a delay element 38 which generates the delay signal 34. The illustration of Figure 2 is a very general representation of the functionality of the integrator 12.

Each differentiator 16, as shown schematically in Figure 3, comprises a subtractor 40 having a first input configured to receive an input signal 42 and a second input configured to receive a delay signal 44. The subtractor 40 operates to subtract the delay signal 44 from the input signal 42 and generate an output signal 46. The delay signal 44 is generated at the output of a delay element 48 whose input also receives the input signal 42. The illustration of Figure 3 is a very general representation of the functionality of the differentiator 16.

Let XNin be the signal at the input of the first integrator 12 in the string, and let n be the index of the samples of the signal x. XNin may be represented as:

$$XNin = x(0), x(1), x(2), \ldots, x(n), \ldots, x(n+k), \ldots$$

Let XNint be the integration signal 20 at the output of the last integrator 12(N). XNint may be represented as:

$$XNint = x(0), x(0)+x(1), x(0)+x(1)+x(2), \ldots, x(0)+x(1)+ \ldots +x(n), \ldots$$

Let XND be the decimated signal 22 at the output of the decimator 14. The decimator 14 functions to output every D-th sample of the signal XNint, which would represent the integration signal 20 at the samples where n = 0, D, 2D, ....

XND may be represented as: XND = X(0), X(D), X(2D), ...
where:

$$X(0)=x(0),$$

$$X(D)=x(0)+x(1)+ \ldots +x(D),$$

$$X(2D)= x(0)+x(1)+ \ldots +x(2D),$$

and so on.

Let XNout be the signal at the output of the (first) differentiator 16(N) in the string. XNout may be represented as:

$$XNout = X(D) - X(0), X(2D) - X(D), X(3D) - X(2D), \ldots$$

This may also be represented as follows:

$$XNout = \sum_{n=0}^{D} x(n) - x(0), \sum_{n=D}^{2D} x(n) - \sum_{n=0}^{D} x(n), \ldots$$

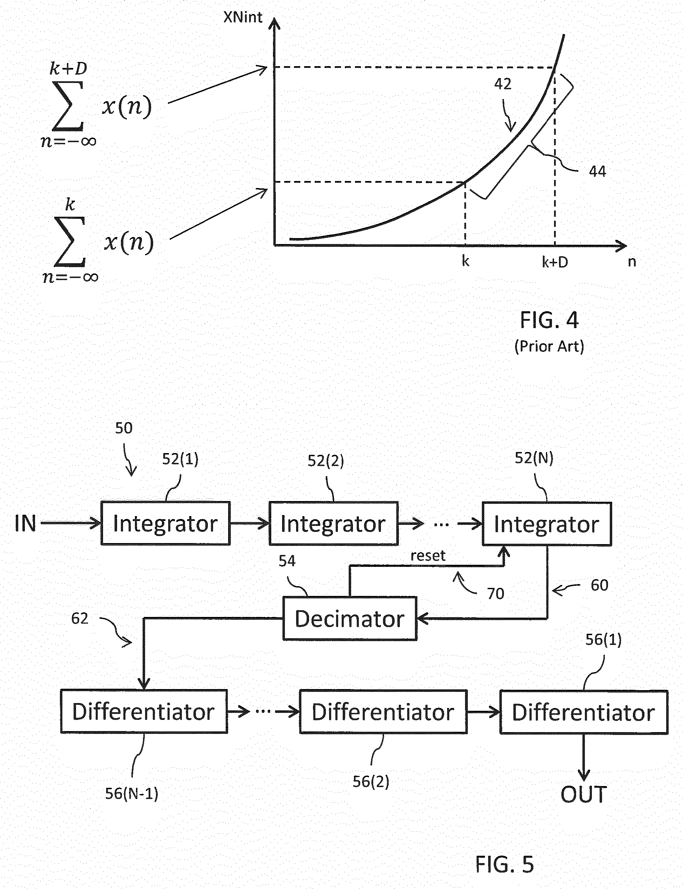

The foregoing may be graphically represented as shown in Figure 4. The graph very generally shows an example of the accumulated values of the integrator 12(N) in the string at reference 42 for an example monotonically increasing input signal. The function of the differentiator 16(N) is to extract the difference portion indicated at reference 44 as XNout = X(k+D) - X(k).

There is a need in the art to reduce the size and power consumption of the CIC decimation filter with negligible or no associated performance penalty.

SUMMARY

In an aspect, a cascaded integrator-comb, CIC, decimation filter comprises: N integrator stages coupled in series; a decimator having an input coupled to receive an integrated signal that is output from the N integrator stages coupled in series; N-1 differentiator stages coupled in series and configured to receive a decimated signal that is output from the decimator.

The N integrator stages coupled in series may include a last integrator stage in the series having an output generating the integrated signal; and the last integrator stage may be controlled to be periodically reset.

The last integrator stage may respond to being periodically reset by accumulating a zero value instead of a delayed value.

The N integrator stages may operate at a first sampling frequency of an input digital signal and the N-1 differentiator stages may operate at a second sampling frequency of an output digital signal.

The decimator may effectuate a rate change from the first sampling frequency to the second sampling frequency.

The decimator may be configured to periodically assert a reset signal which causes the last integrator stage to be periodically reset.

The reset signal may be asserted in conjunction with each output of a sample of the decimated signal.

The reset signal may be asserted at a same rate as a rate change implemented by the decimator.

The last integrator stage may include a feedback delay element, and the periodic reset of the last integrator stage may cause an output of the feedback delay element to be set to zero.

The decimator may be configured to periodically output samples of the decimated signal.

In an aspect a method comprises: integrating samples of an input digital signal via N integrator stages to generate an integration signal; decimating samples of the integration signal via a decimator to generate a decimation signal; and differentiating samples of the decimation signal (via N-1 differentiator stages.

Periodically resetting may comprise accumulating a zero value instead of a delayed value.

The method may further comprise periodically generating an integration reset signal at a same rate as the samples of the integration signal are being decimated to generate the decimation signal; and periodically resetting comprises resetting the integration signal in response to each integration reset signal.

Integrating may operate at a first sampling frequency of the input digital signal and differentiating may operate at a second sampling frequency of an output digital signal.

Decimating may effectuate a rate change from the first sampling frequency to the second sampling frequency.

In an aspect, a cascaded integrator-comb (CIC) decimation filter comprises: N integrator stages coupled in series; a decimator having an input coupled to receive an integrated signal that is output from the N stages of integrators coupled in series; N-1 differentiator stages coupled in series and configured to receive a decimated signal that is output from the decimator; wherein the N integrator stages coupled in series include a last integrator stage in the series having an output generating the integrated signal; and wherein the last integrator stage is controlled to periodically reset the integrated signal.

The last integrator stage may respond to being periodically reset by accumulating a zero value instead of a delayed value.

The N integrator stages may operate at a first sampling frequency of an input digital signal and the N-1 differentiator stages may operate at a second sampling frequency of an output digital signal.

The decimator may effectuate a rate change from the first sampling frequency to the second sampling frequency..

The decimator may be configured to periodically assert a reset signal which causes the last integrator stage to be periodically reset.

The reset signal may be asserted in conjunction with each output of a sample of the decimated signal.

The reset signal may be asserted at a same rate as a rate change implemented by the decimator.

The last integrator stage may include a feedback delay element, and wherein the periodic reset of the last integrator stage causes an output of the feedback delay element to be set to zero.

In an aspect, a cascaded integrator-comb (CIC) decimation filter comprises: N integrator stages coupled in series; a decimator having an input coupled to receive an integrated signal that is output from the N integrator stages coupled in series and configured to periodically output samples of a decimated signal and periodically assert an integration reset signal; and N-1 differentiator stages coupled in series and configured to receive the decimated signal that is output from the decimator; wherein the integration reset signal is applied to one integrator stage of said N integrator stages coupled in series to cause a feedback delay element of the one integrator stage to be reset to zero.

Said one integrator stage may be a last integrator stage of said N integrator stages coupled in series.

The N integrator stages may operate at a first sampling frequency of an input digital signal and the N-1 differentiator stages may operate at a second sampling frequency of an output digital signal.

The decimator may effectuate a rate change from the first sampling frequency to the second sampling frequency.

The integration reset signal may be asserted in conjunction with each output of a sample of the decimated signal.

The integration reset signal may be asserted at a same rate as a rate change implemented by the decimator.

In an aspect, a method comprises: integrating samples of an input digital signal to generate an integration signal; decimating samples of the integration signal to generate a decimation signal; differentiating samples of the decimation signal; and periodically resetting the integration signal.

Periodically resetting may comprise accumulating a zero value instead of a delayed value.

The method may comprise periodically generating an integration reset signal at a same rate as the samples of the integration signal are being decimated to generate the decimation signal; and periodically resetting may comprise resetting the integration signal in response to each integration reset signal.

Integrating may operate at a first sampling frequency of the input digital signal and wherein differentiating operates at a second sampling frequency of an output digital signal.

Decimating may effectuate a rate change from the first sampling frequency to the second sampling frequency.

Periodically resetting may be performed at a same rate as the rate change.

Periodically resetting may comprise resetting a feedback delay signal of an integration operation to zero.

The feedback delay signal may be reset to zero in response to each decimated signal sample output.

BRIEF DESCRIPTION OF THE DRAWINGS

For a better understanding of the aspects, reference will now be made by way of example only to the accompanying figures in which:

Figure 1 shows a schematic view of a conventional N-stage cascaded integrator-comb (CIC) decimation filter;

Figure 2 shows a schematic view of a conventional integrator stage within the CIC decimation filter of Figure 1;

Figure 3 shows a schematic view of a conventional differentiator stage within the CIC decimation filter of Figure 1;

Figure 4 graphically illustrates operation of the CIC decimation filter of Figure 1;

Figure 5 shows a schematic view of an improved N-stage cascaded integrator-comb (CIC) decimation filter with a reduced number of differentiators;

Figure 6 graphically illustrates operation of the CIC decimation filter of Figure 5; and

Figure 7 shows a schematic view of a last integrator stage within the CIC decimation filter of Figure 5.

DETAILED DESCRIPTION

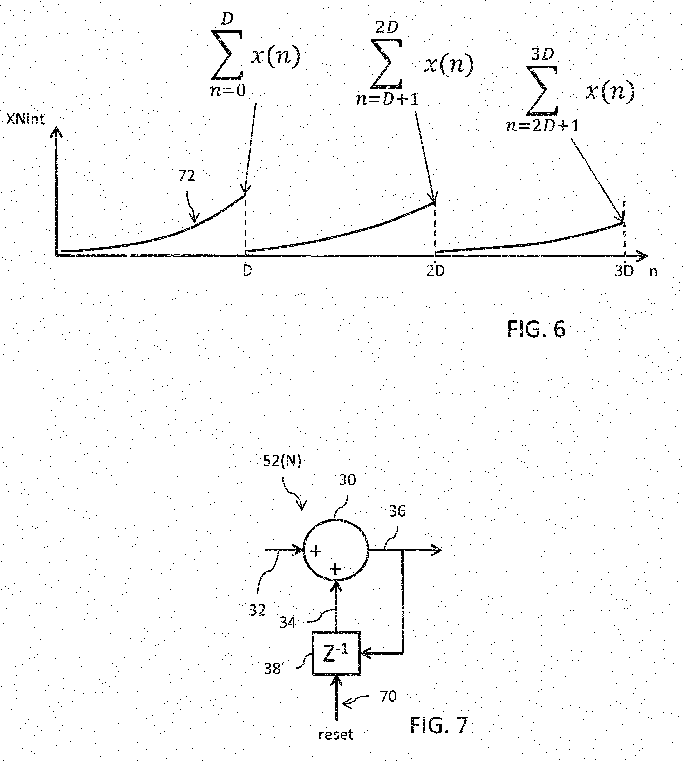

Reference is now made to Figure 5 which shows a schematic view of an N-stage cascaded integrator-comb (CIC) decimation filter 50. While the conventional CIC decimation filter 10 as shown in Figure 1 includes an equal number of stages of integrators 12 and differentiators (or combs) 16, the CIC decimation filter 50 as shown in Figure 5 is instead implemented with an unequal number of stages. More specifically, the CIC decimation filter 50 includes N integration stages and N-1 differentiation stages. The integration stages are provided by N integrators 52(1) to 52(N) and the differentiation stages are provided by N-1 differentiators 56(1) to 56(N-1).
The N stages of integrators 52(1) to 52(N) are connected in cascade series with the (first) integrator 52(1) in the string having an input configured to receive an input signal IN (where the input signal IN is a digital signal and the integrators operate at a sampling frequency of the input digital signal). The output of the integrator 52(1) is coupled to the input of the next integrator 52(2) stage in the string, and this connectivity is repeated across the string of included integrators. The output of the (last) integrator 52(N) stage in the string produces an integration signal 60 that is applied to the input of a rate changer in the form of a decimator 54 (also referred to in the art as a down-sampler). The decimator 54 operates to decimate the integration signal 60 and generate a decimated signal 62. As an example, the decimator 54 may select for output as the decimated signal 62 every D-th sample of the integration signal 60 so as to provide a down sampling rate of D. The N-1 stages of differentiators 56(1) to 56(N-1) are connected in cascade series with the (first) differentiator 56(N-1) stage in the string having an input configured to receive the decimated signal 62. The output of the differentiator 56(N-1) is coupled to the input of the next differentiator 56(N-2) stage in the string, and this connectivity is repeated across the string of included differentiators. The output of the (last) differentiator 56(1) stage in the string produces an output signal OUT which is the result of filtering the input signal IN (where the output signal OUT is a digital signal and the differentiators operate at a sampling frequency of the output digital signal). The down sampling rate of D effectuates the rate change from the sampling frequency of the input digital signal to the sampling frequency of the output digital signal.
Each integrator 52, except for the last integrator 52(N), may be implemented as shown schematically in Figure 2 with respect to integrator 12. Figure 7 shows a schematic view of the last integrator 52(N). The last integrator 52(N) is substantially the same as the integrator 12 of Figure 2, except that the delay element 38' is resettable to zero in response to a reset signal 70. In response to assertion of the reset signal 70, the feedback delay signal 34 is set to zero, and thus the output of the adder 30 when this occurs would be zero plus the input signal 32.
Each differentiator 56 may be implemented as shown schematically in Figure 3 with respect to differentiator 16.
The reset signal 70 is generated by the decimator 54 once every D counts of the decimation operation. In other words, the reset signal 70 is asserted each time the decimator 54 outputs a new sample of the decimated signal 62. In response to the assertion of the reset signal 70, the last integrator 52(N) is reset and the integration signal 60 output from the last integrator 52(N) has a feedback delay contribution of zero. The implementation of the reset operation may be accomplished, as discussed herein with respect to an integrator of the type shown in Figure 7, by resetting a data register associated with the feedback loop of the integrator 52(N) to zero so that next sample of the integration signal 60 is zero plus the output of the (N-1)-th integrator in the string.
It will be noted that the last integrator 52(N) in the string has a non-modulo implementation which is different from the modulo integrator operation of the integrators 12 of the CIC decimation filter 10 of Figure 1. The resetting of the last integrator 52(N) every D-th samples will preclude an overflow from occurring.
Let XNin be the signal at the input of the first integrator 52 in the string, and let n be the index of the samples of the signal x. XNin may be represented as:

$$XNin = x(0), x(1), x(2), ..., x(n), ..., x(n+k), ...$$

Let XNint be the integration signal 60 at the output of the last integrator 52(N). It will be remembered that the last integrator 52(N) is reset once every D counts. XNint may be represented as:

For counts 0 to D; XNint = x(0), x(0)+x(1), x(0)+x(1)+x(2), ..., x(0)+x(1)+ ...+x(D)

For counts D+1 to 2D; XNint = x(D+1), x(D+1)+x(D+2), x(D+1)+x(D+2)+x(D+3), ..., x(D+1)+x(D+2)+...+x(2D).

For counts 2D+1 to 3D; XNint = x(2D+1), x(2D+1)+x(2D+2), x(2D+1)+x(2D+2)+x(2D+3), ..., x(2D+1)+x(2D+2)+...+x(3D). And so on.

Let XND be the decimated signal 62 at the output of the decimator 54. The decimator 54 functions to output every D-th sample of the signal XNint, which would represent the integration signal 20 at the samples where n = 0, D, 2D, ....

$$XND = X(0), X(D), X(2D), ...$$

where:

$$X(0)=XNint(0)=x(0),$$

$$X(D)=XNint(D)=x(1)+ ...+x(D),$$

$$X(2D)=XNint(2D)= x(D+1)+x(D+2)+...+x(2D),$$

$$X(3D)=XNint(3D)= x(2D+1)+x(2D+2)+...+x(3D),$$

and so on.
This may also be represented as follows:

$$XND = \sum_{n=0}^{D} x(n) - x(0), \sum_{n=D}^{2D} x(n) - \sum_{n=0}^{D} x(n), ...$$

Notably, this XND output is equal to the XNout output from the first differentiator 16(N) of the of the CIC decimation filter 10 of Figure 1.
The foregoing may be graphically represented as shown in Figure 6. The graph very generally shows an example of the accumulated values of the last integrator 52(N) in the string at reference 72. The integration operation is reset every D-th sample and the integration starts over again from the current input signal value. Because of this, the last integrator 52(N) output will always represent the difference between consecutive D-th samples. It will be recalled that the calculation of this different is the function performed by the first differentiator 16(N) of the CIC decimation filter 10 of Figure 1. Due to the resetting of the last integrator 52(N) as provided by the CIC decimation filter 50 of Figure 5, it is possible to eliminate the need for the first differentiator 16(N) in the conventional CIC decimator filter 10 and this is why the CIC decimation filter 50 of Figure 5 includes only (N-1) differentiators 56.

It will be noted that the example shown in Figure 7 is correct for the case of a monotonically rising input signal only. This is, of course, just one of many possibilities (rising, falling, mixed, etc.) and thus is only an example presented to illustrate the concept of the effect of periodically resetting the last integrator.

The implementation of the CIC decimation filter 50 of Figure 5 provides a number of advantages over prior art CIC implementations. The advantages include: a) there is no need for an extra data path; b) there is no control penalty; c) the circuit occupies less space and operates at a reduced power level; d) there is support for multiple decimation rate modes (i.e., D can be programmed to any value without area penalty as only the time of reset is being altered and the remainder of the circuit stays the same); e) there is an elimination of one differentiator in comparison to prior art CIC filters; and f) performance is identical to the prior art CIC filter at least because the system transfer function is same.

The system of Figure 5 can be implemented in any suitable hardware, software, firmware, or a combination thereof, without departing from the scope of the invention.

The system may include a processor and a memory, the memory having the computer executable instructions for executing a process for implementing the CIC filtering operation. The computer executable instructions, in whole or in part, may also be stored on a computer readable medium separated from the system on which the instructions are executed. The computer readable medium may include any volatile or non-volatile storage medium such as flash memory, compact disc memory, and the like.

While the invention has been illustrated and described in detail in the drawings and foregoing description, such illustration and description are considered illustrative or exemplary and not restrictive; the invention is not limited to the disclosed aspects. Other variations to the disclosed aspects can be understood and effected by those skilled in the art in practicing the claimed invention, from a study of the drawings, the disclosure, and the appended claims.

**Claims**

1.   A cascaded integrator-comb, CIC, decimation filter, comprising:

   N integrator stages (52) coupled in series;
   a decimator (54) having an input coupled to receive an integrated signal (60) that is output from the N integrator stages (52) coupled in series;
   N-1 differentiator stages (56) coupled in series and configured to receive a decimated signal (62) that is output from the decimator (54).

2.   The CIC decimation filter of claim 1, wherein the N integrator stages (52) coupled in series include a last integrator stage (52) in the series having an output generating the integrated signal (60); and
   wherein the last integrator stage (52) is controlled to be periodically reset.

3.   The CIC decimation filter of claim 2, wherein the last integrator stage (52) responds to being periodically reset by accumulating a zero value instead of a delayed value.

4.   The CIC decimation filter of any of claims 1 to 3, wherein the N integrator stages (52) operate at a first sampling frequency of an input digital signal and wherein the N-1 differentiator stages (56) operate at a second sampling frequency of an output digital signal.

5.   The CIC decimation filter of claim 4, wherein the decimator (54) effectuates a rate change from the first sampling frequency to the second sampling frequency.

6.   The CIC decimation filter of any of claims 2 to 5, wherein the decimator (54) is configured to periodically assert a reset signal (70) which causes the last integrator stage (52) to be periodically reset.

7.   The CIC decimation filter of claim 6, wherein the reset signal (70) is asserted in conjunction with each output of a sample of the decimated signal.

8.   The CIC decimation filter of any of claims 6 or 7, wherein the reset signal is asserted at a same rate as a rate change implemented by the decimator.

9.   The CIC decimation filter of any of claims 2 to 8, wherein the last integrator stage (52) includes a feedback delay element, and wherein the periodic reset of the last integrator stage (52) causes an output of the feedback delay element to be set to zero.

10. The CIC decimation filter of any of claims 1 to 9, wherein the decimator (54) is configured to periodically output samples of the decimated signal (62).

11. A method, comprising:

integrating samples of an input digital signal via N integrator stages (52) to generate an integration signal (60); decimating samples of the integration signal (60) via a decimator (54) to generate a decimation signal (62); and differentiating samples of the decimation signal (62) via N-1 differentiator stages (56).

12. The method of claim 11, wherein periodically resetting comprises accumulating a zero value instead of a delayed value.

13. The method of any of claims 11 or 12, further comprising:

periodically generating an integration reset signal (60) at a same rate as the samples of the integration signal are being decimated to generate the decimation signal; and wherein periodically resetting comprises resetting the integration signal (60) in response to each integration reset signal (70).

14. The method of any of claims 11 to 13, wherein integrating operates at a first sampling frequency of the input digital signal and wherein differentiating operates at a second sampling frequency of an output digital signal.

15. The method of claim 14, wherein decimating effectuates a rate change from the first sampling frequency to the second sampling frequency.

FIG. 1
(Prior Art)

FIG. 2
(Prior Art)

FIG. 3
(Prior Art)

$$\sum_{n=-\infty}^{k+D} x(n)$$

$$\sum_{n=-\infty}^{k} x(n)$$

FIG. 4
(Prior Art)

FIG. 5

$$\text{XNint} \qquad \sum_{n=0}^{D} x(n) \qquad \sum_{n=D+1}^{2D} x(n) \qquad \sum_{n=2D+1}^{3D} x(n)$$

72

D            2D            3D   n

FIG. 6

52(N)    30    36

32    34

$Z^{-1}$

38'

70

reset    FIG. 7

Europäisches
Patentamt

European
Patent Office

Office européen
des brevets

# EUROPEAN SEARCH REPORT

Application Number

EP 19 17 7367

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 4 872 129 A (PFEIFER HEINRICH [DE] ET AL) 3 October 1989 (1989-10-03) * column 1, line 6 - line 10 * * column 2, line 24 - column 3, line 54; claim 1; figures 1, 2 * | 1-15 | INV. H03H17/06 |
| X | WO 2016/201216 A1 (ANALOG DEVICES INC [US]) 15 December 2016 (2016-12-15) * paragraph [0022] - paragraph [0029]; figures 1 - 3 * | 1-15 | |
| X | EP 0 889 586 A1 (MICRONAS SEMICONDUCTOR HOLDING [CH]) 7 January 1999 (1999-01-07) * page 3, line 29 - page 5, line 46; claim 3; figures 1 - 4 * | 1-15 | |
| X | US 2009/079600 A1 (NOESKE CARSTEN [DE]) 26 March 2009 (2009-03-26) * paragraph [0023]; figures 1A, 1B * | 1-15 | |
| X | HOGENAUER E B: "AN ECONOMICAL CLASS OF DIGITAL FILTERS FOR DECIMATION AND INTERPOLATION", IEEE TRANSACTIONS ON ACOUSTICS, SPEECH AND SIGNAL PROCESSING, IEEE INC. NEW YORK, USA, vol. 29, no. 2, 1 April 1981 (1981-04-01), pages 155-162, XP000560569, ISSN: 0096-3518, DOI: 10.1109/TASSP.1981.1163535 | 1,4,5, 10,11, 14,15 | TECHNICAL FIELDS SEARCHED (IPC) H03H |
| A | * II. CIC Filter Description; page 155, right-hand column - page 156, right-hand column; figures 1, 2 * | 2,3,6-9, 12,13 | |

The present search report has been drawn up for all claims

| Place of search | Date of completion of the search | Examiner |
|---|---|---|
| Munich | 17 October 2019 | Trafidlo, Renata |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 19 17 7367

This annex lists the patent family members relating to the patent documents cited in the above-mentioned European search report.
The members are as contained in the European Patent Office EDP file on
The European Patent Office is in no way liable for these particulars which are merely given for the purpose of information.

17-10-2019

| Patent document cited in search report | | Publication date | Patent family member(s) | | Publication date |
|---|---|---|---|---|---|
| US 4872129 | A | 03-10-1989 | CN | 1035215 A | 30-08-1989 |
| | | | EP | 0320517 A1 | 21-06-1989 |
| | | | JP | H0773184 B2 | 02-08-1995 |
| | | | JP | H02140009 A | 29-05-1990 |
| | | | US | 4872129 A | 03-10-1989 |
| WO 2016201216 | A1 | 15-12-2016 | CN | 107636965 A | 26-01-2018 |
| | | | US | 2018159510 A1 | 07-06-2018 |
| | | | WO | 2016201216 A1 | 15-12-2016 |
| EP 0889586 | A1 | 07-01-1999 | DE | 59710809 D1 | 06-11-2003 |
| | | | EP | 0889586 A1 | 07-01-1999 |
| US 2009079600 | A1 | 26-03-2009 | DE | 102007046181 A1 | 02-04-2009 |
| | | | EP | 2043264 A1 | 01-04-2009 |
| | | | KR | 20090031985 A | 31-03-2009 |
| | | | US | 2009079600 A1 | 26-03-2009 |

EPO FORM P0459

For more details about this annex : see Official Journal of the European Patent Office, No. 12/82